# EUROPEAN PATENT SPECIFICATION

(11) **EP 0 276 345 B1**
(45) Date of publication and mention of the grant of the patent: **17.03.1993**
(21) Application number: 87101150.8
(22) Date of filing: 28.01.1987
(51) Int. Cl.: H01L 21/48, H01L 23/12, H01L 23/48

(54) **Elastic bladder method of fabricating an integrated circuit package having bonding pads in a stepped cavity**
Verfahren, das eine elastische Folie benutzt zum Herstellen einer integrierten Schaltungspackung mit Kontaktflecken in einer abgestuften Grube
Procédé utilisant une feuille élastique pour la fabrication d'un empaquetage à circuit intégré ayant des plages de contact dans une cavité échelonnée

(43) Date of publication of application: 03.08.1988
(73) Proprietor: UNISYS CORPORATION, Detroit, Michigan 48232 (US)
(72) Inventor: Norrell, Ronald Allen, Carlsbad California 92008 (US)
(74) Representative: Eisenführ, Speiser & Partner

(56) References cited:
- EP-A- 0 023 400
- EP-A- 0 262 848
- WO-A-84/01470
- PATENT ABSTRACTS OF JAPAN, vol. 10, no. 289 (E-442)[2345], 2nd October 1986; & JP-A-61 108 153

## Description

### BACKGROUND OF THE INVENTION

This invention relates to integrated circuit packages and methods for fabricating such packages.

One common integrated circuit package of the prior art is comprised of a plurality of thin flat ceramic layers which are laminated together and which have a cavity that holds an integrated circuit chip. This cavity in cross section has staircase-shaped sidewalls. Patterned electrical conductors lie on the surfaces of the ceramic layers; and, on the steps of the cavity, these conductors are shaped as wire bonding pads. Discrete wires are bonded between these bonding pads and the integrated circuit chip to carry signals to and from the chip.

Since the cavity is staircase-shaped, several rows of bonding pads lie around the chip. This is desirable because it enables a large number of signals to be sent to and from the chip. A trend in integrated circuits is to increase the number of these signals, and today chips are fabricated with over 100 bonding pads.

A problem, however, with the above described integrated circuit package is that it is expensive to manufacture. One factor in this expense is the cost of a furnace which is needed to cure the ceramic at temperatures of about 1538°C (2800°F). Also, the furnace must be operated 24 hours a day to keep its temperature stable.

Another factor in this expense is low yield. During the curing process, the ceramic shrinks at rates which are very difficult to control and this makes some packages unusable. Also during the curing process, blisters can occur between some of the ceramic layers in the packages; and some of the conductors may not properly adhere to the ceramic layers. These problems combined typically lower the yield of ceramic packages to only 5%-50%.

Accordingly, efforts have been made to develop a lower cost package; and to that end, epoxy-glass has been used in place of ceramic. This change of materials eliminates all of the above described furnace problems, shrinkage problems, blister problems, and conductor adhesion problems. However, with epoxy-glass packages, adhesive layers are needed between the epoxy-glass layers in order to laminate and permanently hold the epoxy-glass layers together. No such adhesive is needed in ceramic packages, and this adhesive causes new problems.

Specifically, during lamination of the epoxy-glass layers, the adhesive softens and flows; and if the adhesive flows over the bonding pads on the steps of the staircase-shaped cavity, the package becomes unusable. A cured adhesive on the bonding pads cannot be removed without destroying the pads.

In the prior art, the cavity merely had vertical sidewalls and the bonding pads were placed on only the top epoxy-glass layer. This, however, has a serious drawback in that it severely limits the number of signals that can be sent to and received from the integrated circuit chip.

EP-A-0 262 848 which is only an Article 54 (3) EPC document for the contracting states AT, BE, CH, DE, FR, GB, LI, NL and SE discloses a method for laminating multilayer structures which include a staircase-chaped cavity formed therein. A conformal material, a release material, and an optional template are provided over the structure prior to the lamination bonding operation. The conformal and release materials then fill the cavity during the bonding operation to prevent flow of adhesive from between the layers into the cavity, and the template redistributes cavity edge stresses to minimize wire bonding pad deflections. Subsequent to the bonding cycle, the conformal and release materials are mechanically lifted off the multilayer structure. This is done easily since the release material prevents sticking of the conformal material to the structure. The combination of conformal and release materials can then be discarded.

Accordingly, a primary object of the invention is to provide an improved integrated circuit package and method of fabricating same which overcomes all of the above prior art problems.

### BRIEF SUMMARY OF THE INVENTION

With the present invention, an integrated circuit package is fabricated by assembling a stack which is comprised of a plurality of thin flat dielectric layers, and a staircase-shaped cavity. This cavity extends from an outer dielectric layer through an internal dielectric layer, and exposes a portion of the flat surface of the internal dielectric layer. Conductors lie on the internal dielectric layer including bonding pads on the exposed flat surface portion. After the stack is assembled, the outer dielectric layer and the cavity are covered with an elastic membrane. Subsequently, the stack is laminated by forcing a fluid against the membrane at a temperature and pressure which causes the membrane to stretch and push against all the surfaces of the cavity. Then, the elastic membrane is unstretched by decompressing the fluid, because, the elastic membrane is formed such that it tends to return to its unstretched state, whereby the elastic membrane comes out of the cavity by itself.

### BRIEF DESCRIPTION OF THE DRAWINGS

Various features and advantages of the invention are described in the Detailed Description in accordance with the accompanying drawings wherein:
FIG. 1 is a greatly enlarged cross-sectional view of a preferred embodiment of an integrated circuit package that is constructed in accordance with the invention;
FIGs. 2-5 illustrate the steps of one preferred method of fabricating the integrated circuit package of FIG. 1; and
FIGs. 6-7 illustrate the steps of another preferred method of fabricating the integrated circuit package of FIG. 1.

### DETAILED DESCRIPTION OF THE INVENTION

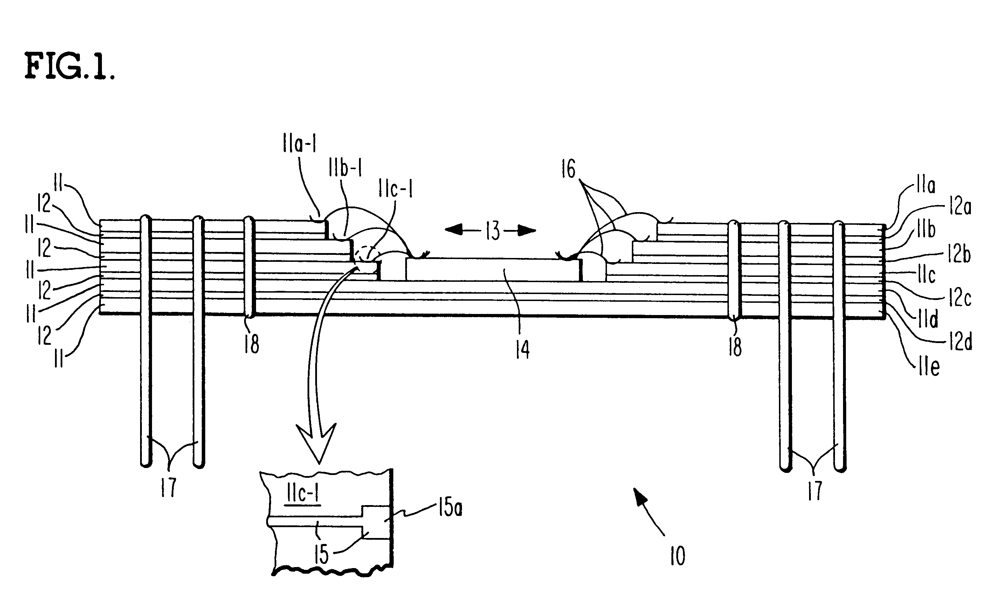

Referring now to FIG. 1, the details of a novel integrated circuit package 10 will be described. Package 10 includes a total of five thin flat epoxy-glass layers 11 which are arranged in a stack. These epoxy-glass layers are held together by respective adhesive layers 12 which lie between the epoxy-glass layers. Suitably the adhesive layers are made of prepreg.

In FIG. 1, the layers 11 and 12 are shown in cross section at approximately five times the size of the actual package. In the actual embodiment, each of the layers 11 and 12 is square in shape and 3.81 cm (1.5 inches) on a side. Also, each of the epoxy-glass layers 11 is 0.381 mm (0.015 inches) thick, and each of the adhesive layers 12 is 0.1016 mm (0.004 inches) thick.

Package 10 also has a cavity 13 in which an integrated circuit die 14 is disposed. This cavity 13 penetrates through layers 11a, 12a, 11b, 12b, 11c, and 12c. In cross section, cavity 13 is staircase-shaped so that it exposes a portion 11b-1 of the flat surface of layer 11b and exposes a portion 11c-1 of the epoxy-glass flat surface of layer 11c. Cavity 13 is 1.676 cm (0.66 inches) wide in layers 11a and 12a, 1.422 cm (0.56 inches) wide in layers 11b and 12b, and 1.168 cm (0.46 inches) wide in layers 11c and 12c.

Layers 11a, 11b and 11c have patterned electrical conductors on their flat surface. These conductors are only about 0.0254 mm (0.001 inches) high, which is too thin to show in cross section. However, one such conductor is indicated from a top view by reference numeral 15. These conductors are provided to carry electrical signals to and from chip 14. To accomplish that, each conductor includes a bonding pad 15a on one of the exposed surface portions 11a-1, 11b-1 and 11c-1.

Signals are carried between the bonding pads 15a and corresponding pads on chip 14 by a plurality of discrete bonding wires 16. To carry signals to and from the package itself, a plurality of metal pins 17 are provided which fit tightly into respective narrow holes in the layers 11 and 12 and make contact with the conductors 15. Metal plated holes 18 are provided which contact the electrical conductors 15 on two epoxy-glass layers at the same time and thereby transfer signals from one layer to the other.

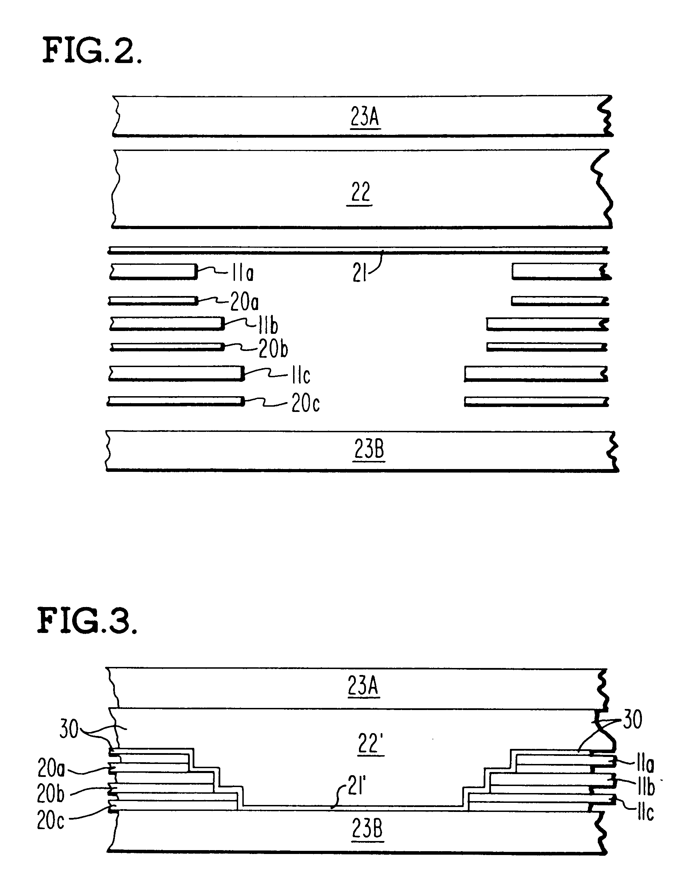

Turning now to FIGs. 2-5, the details of a method for constructing the FIG. 1 integrated circuit package will be described. In this method, a thermoplastic plug is used which has a shape that closely matches the shape of cavity 13; and the steps for forming such a plug are illustrated in FIGs. 2 and 3.

To begin, all of the epoxy-glass layers through which the cavity 13 penetrates (i.e., layers 11a, 11b, and 11c) are assembled in a stack. Between those layers, non-adhesive "dummy" layers 20a, 20b, and 20c are disposed. These "dummy" layers have the same thickness and cavity shape as the adhesive layers 12a, 12b, and 12c; and suitably, they are comprised of epoxy-glass.

A thin sheet 21 of a "release" material (i.e., a material which does not stick to the epoxy-glass layers 11a-11c and the adhesive layers 12a-12d under high temperature and pressure) is placed on top of the assembly. Suitably, sheet 21 is a 0.0254 mm (0.001 inch) thick sheet of Tedlar (trademark). Thereafter, a layer 22 of thermoplastic material is placed on top of sheet 21. Suitably, layer 22 is a 1.524 mm (0.060 inch) thick layer of a polyvinyl chloride, a polyolefin, or a polycarbonate.

All of the above described FIG. 2 layers are then compressed by two pressure plates 23a and 23b. This compression occurs at a temperature which causes the thermoplastic layer 22 to soften, and at a pressure which forces the softened thermoplastic material to completely fill the cavity that is formed by layers 11a-11c and 20a-20c.

Suitably this compression occurs at 148.89°C (300°F) and 2068.428 kPa (300 psi) and lasts for 40 minutes. Figure 3 shows the result of this compression step. In that figure, reference numeral 30 indicates the finished thermoplastic plug which consists of the shaped thermoplastic material 22' and its surface film 21' of release material.

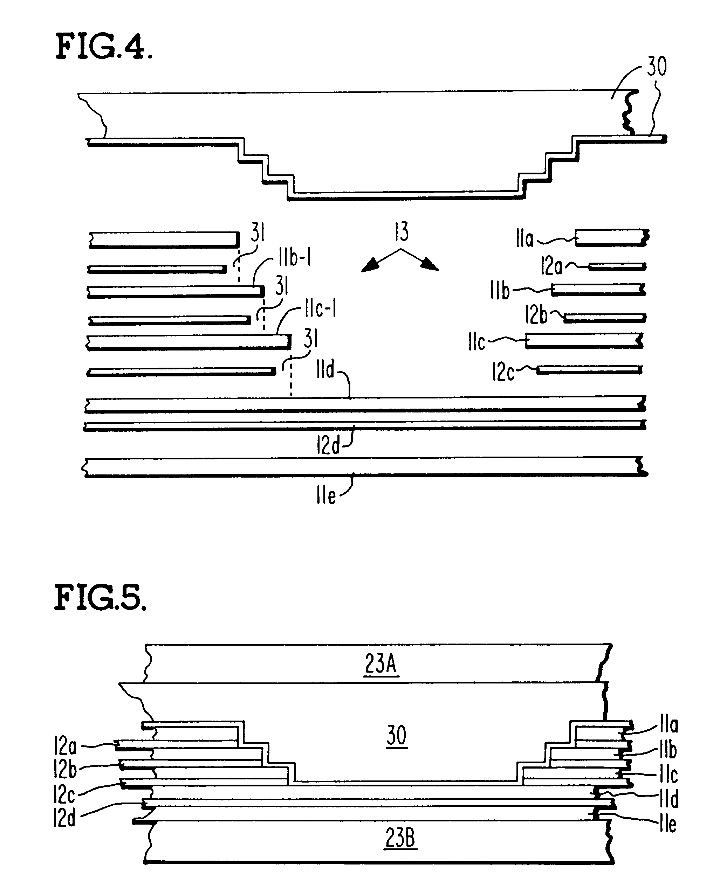

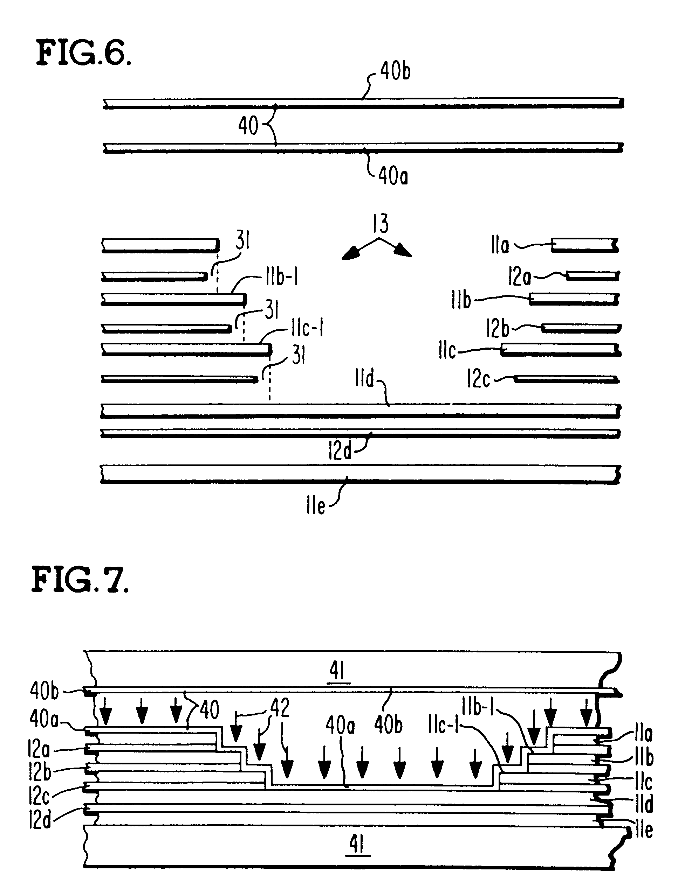

Turning next to FIGs. 4 and 5, the steps by which the thermoplastic plug 30 is used to fabricate the integrated circuit package 10 will be described. To begin, all of the epoxy-glass layers 11a-11e are assembled in a stack, and all of the adhesive layers 12a-12d are interleaved between the epoxy-glass layers. Preferably, those adhesive layers through which cavity 13 extends (i.e., layers 12a, 12b, and 12c) are recessed at the cavity from their overlying epoxy-glass layer. This recess is indicated by reference numeral 31, and suitably, it is 0.508 mm (0.020 inches).

Note that prior to making the FIG. 4 assembly, the previously described patterned conductors 15 have already been formed on the internal epoxy-glass layers. These conductors are formed by conventional steps such as attaching a thin unpatterned copper film to one surface of each internal epoxy-glass layer, patterning a layer of photoresist over the copper film in accordance with the desired conductor pattern, and using a chemical etchant to remove all portions of the copper film which are not covered by the photoresist. In performing these steps, the previously described bonding pads 15a in the regions 11b-1 and 11c-1 are also fabricated.

After layers 11 and 12 are assembled as per FIG. 4, the thermoplastic plug 30 is inserted into the cavity 13. Due to the manner in which plug 30 is made (i.e., by the process steps of FIGs. 2 and 3), plug 30 will fit snugly into cavity 13. However, small voids between the plug and some of the layers 11a, 11b, 11c, 12a, 12b, and 12c sidewalls of the cavity will always occur. Preferably, the width of plug 30 should be no more than 0.127 mm (0.005 inches) smaller than the width of cavity 13.

Thereafter, the stacked layers 11 and 12 with the inserted plug 30 is placed between the pressure plates 23a and 23b of a press and laminated. This lamination occurs at a temperature and pressure which causes the plug 30 to soften and conform exactly to the shape of cavity 13. Suitably, this lamination occurs at a temperature of 176.67°C (350°F) and a pressure of 2068.428 kPa (300 psi) and lasts for 60 minutes. Figure 5 illustrates the result of this step.

An important feature of the above described fabrication process is that no adhesive from any adhesive layer flows over the bonding pads on surfaces 11b-1 and 11c-1. This is because plug 30 softens during the lamination process before the adhesive softens, and so it fills all voids between the plug and the layers 11 and 12 before the adhesive layers 11 soften. For example, a polyvinyl chloride plug 30 softens at 71.11°C-93.33°C (160°F-200°F) whereas prepreg adhesive layers 12 soften at 121.11°C-126.67°C (250°F-260°F).

Thus, plug 30 acts as a dam which prevents the adhesive in layers 12a, 12b, and 12c from flowing onto the bonding pads. Without this damming action, the adhesive would flow over and harden on the bonding pads, and that would make the package unusable since the hardened adhesive cannot be removed without severely damaging the package.

Another important feature of the above described process is that during lamination, pressure is applied uniformly over all of the flat surfaces of the layers 11 and 12, including the bonding pad regions 11b-1 and 11c-1. This uniformity in pressure is another result of the thermoplastic plug softening and conforming exactly to the shape of cavity 13. Consequently, the "steps" on which the bonding pads 15a are located are square and not sloped, the thickness of the adhesive layers 12 is uniform, and tolerances on the thickness of the epoxy-glass layers 12 can be relaxed and thereby lower manufacturing costs.

After the lamination step of FIG. 5 is complete, the laminated layers 11 and 12 are removed from the press, and the thermoplastic plug 30 is removed from cavity 13. Thereafter, respective narrow holes are drilled for each of the metal pins and metal plated holes in the package, pins 17 are fitted into their holes and soldered in place, and the remaining holes 18 are metal plated.

Next, referring to FIGs. 6 and 7, still another process for fabricating the integrated circuit package 10 will be described. With this process, no preformed thermoplastic plug is needed. Instead, each of the epoxy-glass layers 11a-11e and the adhesive layers 12a-12d are arranged in a stack just as they were in FIG. 4. Subsequently, as FIG. 6 shows, the outer epoxy-glass layer 11a of this stack is covered with a thin (e.g., 0.762 mm (0.030 inch) thick) elastic bladder 40. Suitably, the bladder 40 is made of rubber or any other elastomer which can withstand the temperatures and pressures that occur during lamination.

Bladder 40 and the stacked layers 11 and 12 are placed in an enclosed rigid box 41, and thereafter a fluid 42 is forced into the bladder. This occurs at a pressure and temperature which causes the bladder's membrane 40a to stretch and push against all the surfaces of cavity 13. At the same time layers 11a-11e and 12a-12d are laminated together. This is illustrated in FIG. 7 wherein the arrows 42 indicate the pressurized fluid. Here, as with the thermoplastic plug, a suitable pressure and temperature is 2068.428 kPa (300 psi) at 176.67°C (350°F) for 60 minutes.

With membrane 40a so stretched, it acts as a dam for the adhesive in layers 12a, 12b, and 12c and prevents the adhesive from flowing onto the bonding pads 15a. In addition, the fluid 42 operates to distribute the pressure uniformly over all of the flat surfaces of layers 11a-11e and 12a-12d. Consequently, the steps in cavity 13 are square, no localized overthinning of the adhesive layers occurs, and tolerances on the thickness of the layers 11 and 12 can be relaxed.

This method of FIGs. 6 and 7 also has an added advantage over the method of FIGs. 2-5 in that a single bladder 40 works for all cavity sizes. Thus, a separate preformed plug is not needed for each different cavity size.

Another added feature of the method of FIGs. 6 and 7 is that it doesn't incorporate the use of a press; only a box and a fluid pump are used. This reduces the method's cost since a box and a hand pump can be obtained for about $100 whereas a press costs several thousand dollars.

Still another added feature of the method of FIGs. 6 and 7 is that after the lamination step is complete, the elastic membrane 40a can be removed from cavity 13 more easily than a plug. This is because when the pressure in fluid 42 is reduced, the elastic membrane 40a will tend to return to its flat unstretched state and thereby come out of the cavity by itself.

All of the details of a novel integrated circuit package as well as two methods for fabricating that package have now been completely described. In addition, however, many changes and modifications, as shown below, can be made to these details.

For example, the adhesive layers 12a-12d can be made of all types of prepreg, i.e. - all fabric supported thermosetting resins which have been cured to an intermediate stage. Suitable fabric materials include glass, Tedlar (trademark), and quartz; and suitable resins include epoxy, polyimide, triazine, teflon, and acrylics. Alternatively, the adhesive layers 12a-12d can be made of a sheet of partially cured thermosetting resin without any interwoven fabric material. Also, the thickness of these adhesive layers can vary, but preferably the thickness is at least 0.0508 mm (0.002 inches) so that when the adhesive softens during lamination, it has enough volume to fill the spaces between the conductors 15.

In addition, layers 11a-11e are not limited to epoxy-glass; they can be fabricated from any dielectric material. Suitable materials include fabric supported thermosetting resins as identified above but which have been fully cured, and those same thermosetting resins without any interwoven fabric which have been fully cured.

Another dielectric for layers 11a-11e is ceramic. When ceramic layers are assembled in accordance with the process steps of FIGs. 2, 4, and 6, those ceramic layers are in their uncured or green state; and the process steps of FIGs. 5 and 7 compress the ceramic layers to a state where they can be cured in a furnace.

When the layers 11a-11e are made of ceramic, they may be laminated together without an adhesive between them. In that case, the dummy layers 20a-20c in FIGs. 2 and 3 and the adhesive layers 12a-12d in FIGs. 4-7 are eliminated. Alternatively, a light spray of an adhesive may be put on the surface of layers 11a-11c prior to their lamination. Ceramic layers with and without adhesive between them may be laminated to ether by the steps of FIGS. 5 and 7 at a temperature of 54.44°C (130°F) and a pressure of 8618.45-11376.35 kPa (1250-1650 psi) for two minutes.

When ceramic is being cured, it has a tendency to shrink, and the degree to which it shrinks varies inversely with the ceramic's density. With the above method, all of the green ceramic layers are compressed to a uniform density throughout the package; and so during curing, all layers throughout the package shrink uniformly. Thus, with the above method, the registration of the conductors 15 and the bonding pads 15a around cavity 13 is very accurate.

Green ceramic almost always contains small quantities of moisture; and during lamination this moisture vaporizes and tries to escape from the package. If the pressure during lamination is not applied uniformly on all of the green ceramic layers, this gas will become trapped between any two layers where the pressure is low and thereby create a "blister". But with the method of FIGs. 2-5 and 6-7, pressure is applied uniformly to the ceramic layers and so no such blisters occur.

In addition, the conductors 15 on the green ceramic layers extend slightly above the layers' flat surface (e.g., 0.0254 mm (0.001 inches) above); and if pressure is applied to these conductors nonuniformly during lamination, they will get squashed into the ceramic at nonuniform depths. This is undesirable because it causes the conductors to adhere to the ceramic nonuniformly. But with the methods of FIGs. 2-5 and 6-7, all squashing occurs uniformly since a uniform pressure is applied to the conductors and the ceramic at the same time. Thus the degree with which all the conductors adhere to the ceramic in the finished package is uniform and can be controlled.

As another modification to the above described details, the number of layers in the package 10 may be increased. For example, by providing an additional layer 11 and an additional layer 12 and by extending cavity 13 through them in a staircase-shaped fashion, extra bonding pads can be placed around the cavity for the integrated circuit chip 14.

Still another modification to the above described details is that the preformed plug 30 which is fabricated by the steps of FIGs. 2 and 3 may be made of a material other than a thermoplastic. Any material that softens under the temperature and pressure that is used during lamination and does not irreversibly harden upon cooling may be used. For example, a low durometer rubber (i.e., one with a durometer rating of less than Shore A 30) may be used in place of the thermoplastic material.

As yet another modification, the bladder 40 of FIGs. 6 and 7 need not be a sack or a bag that is elastic on all sides. Only the side 40a which presses against the top layer 11a of the stack need be an elastic membrane; the other side 40b can be a rigid sheet or housing.

Also, the temperature and pressure at which lamination occurs in the steps of FIGs. 3, 5 and 7 are not limited to those which were previously stated. Preferably, however, these lamination steps are carried out at pressures of at least 344.74 kPa (50 psi) and temperatures of at least 37.78°C (100°F).

## Claims

1. A method of fabricating an integrated circuit package including the steps of:
assembling a stack which is comprised of a plurality of thin flat dielectric layers (11a - e), a staircase-shaped cavity (13) which extends from one outer dielectric layer (11a) through an internal dielectric layer (11c) and exposes a portion of the flat surface of said internal dielectric layer (11c), and conductors (15) on said internal dielectric layer (11c) including bonding pads (15a) on the exposed flat surface portion;
covering said cavity (13) with an elastic membrane (40a); and permanently joining the layers (11a - d) of said stack by compressing them with a fluid (42) which is forced against said elastic membrane (40a) at a temperature and pressure which causes the membrane (40a) to stretch and conform exactly to the surface of said cavity (13); and unstretching said elastic membrane (40a) by decompressing said fluid (42), said elastic membrane (40a) being formed such that it tends to return to its unstretched state.

2. A method according to claim 1 wherein said dielectric layers (11a - e) are epoxy-glass layers which are separated by adhesive layers (12a - d).

3. A method according to claim 1 wherein said dielectric layers (11a - e) are green-ceramic layers.

4. A method according to claim 1 wherein said membrane is a rubber membrane.

5. A method according to claim 1 wherein said membrane is one portion of an elastic bladder (40) that is enclosed except for an opening that passes said fluid.

6. A method according to claim 1 wherein said membrane (40a) has a surface which resists sticking to said dielectric layer (11a - d).

7. A method according to claim 1 wherein said membrane (40a) extends beyond said cavity (13) and covers the flat surface of said outer dielectric layer (11a).

8. A method according to claim 1 wherein said temperature and pressure respectively are at least 37.78°C (100°F) and at least 344.74 kPa (50 psi).

9. A method according to claim 1 wherein said membrane lies across said cavity and is attached at its perimeter to a rigid housing.

10. A method according to claim 2 wherein said adhesive layers (12a - d) include thermosetting resins which have been cured to an intermediate stage.

11. A method according to claim 10 wherein said adhesive layers (12a - d) further include and are supported by an interwoven fabric.

12. A method according to claim 1 wherein said dielectric layers (11a - e) include thermosetting resins which have been fully cured.

13. A method according to claim 12 wherein said dielectric layers (11a - e) further include and are supported by an interwoven fabric.

## Patentansprüche

1. Verfahren zum Herstellen einer integrierten Schaltungspackung mit den Schritten:
Aufbau eines Stapels umfassend mehrere dünne flache dielektrische Schichten (11a-e), eine treppenartige Vertiefung (13), die sich von einer äußeren dielektrischen Schicht (11a) durch eine innere dielektrische Schicht (11c) erstreckt und einen Teil der flachen Oberfläche der inneren dielektrischen Schicht (11c) offen läßt und Leiter (15) auf der inneren dielektrischen Schicht (11c), welche Bindungspolster (15a) auf den freigelassenen Teilen der flachen Oberfläche einschließen;
Bedecken der Vertiefung (13) mit einer elastischen Membran (40a); und
dauerhaft Verbinden der Schichten (11a-d) des Stapels durch Verdichten der Schichten mit einem Fluid (42), welches gegen die elastische Membran (40a) bei einer Temperatur und einem Druck gepreßt wird, die dazu führen, daß die Membran (40a) sich reckt und sich genau an die Oberfläche der Vertiefung (13) anpaßt; und
Entrecken der elastischen Membran (40) durch Dekomprimieren des Fluids (42), wobei die elastische Membran (40a) so geformt wird, daß sie in ihren entreckten Zustand zurückstrebt.

2. Verfahren nach Anspruch 1, wobei die dielektrischen Schichten (11a-e) Epoxyglasschichten sind, die durch Klebeschichten (12a-d) getrennt sind.

3. Verfahren nach Anspruch 1, wobei die dielektrischen Schichten (11a-e) grünkeramische Schichten sind.

4. Verfahren nach Anspruch 1, wobei die Membran eine Gummimembran ist.

5. Verfahren nach Anspruch 1, wobei die Membran einen Teil einer elastischen Blase (40) darstellt, die mit Ausnahme einer Öffnung, die das Fluid leitet, abgeschlossen ist.

6. Verfahren nach Anspruch 1, wobei die Membran (40a) eine Oberfläche aufweist, die dem Ankleben an die dielektrische Schicht (11a-d) widersteht.

7. Verfahren nach Anspruch 1, wobei die Membran (40a) sich jenseits der Vertiefung (13) erstreckt und die flache Oberfläche der äußeren dielektrischen Schicht (11a) bedeckt.

8. Verfahren nach Anspruch 1, wobei die Temperatur bzw. der Druck mindestens 37,78 °C (100 °F) und mindestens 344,74 kPa (50 psi) betragen.

9. Verfahren nach Anspruch 1, wobei die Membran über der Vertiefung liegt und an ihrer äußeren Begrenzung an einem festen Gehäuse angebracht ist.

10. Verfahren nach Anspruch 2, wobei die Klebeschichten (12a-d) thermisch wärmehärtende Harze einschließen, die bei einem Zwischenschritt gehärtet worden sind.

11. Verfahren nach Anspruch 10, wobei die Klebeschichten (12a-d) weiter ein zwischengewebtes Textilerzeugnis einschließen und davon gestützt werden.

12. Verfahren nach Anspruch 1, wobei die dielektrischen Schichten (11a-e) thermisch härtende Harze einschließen, die vollständig gehärtet worden sind.

13. Verfahren nach Anspruch 12, wobei die dielektrischen Schichten (11a-e) weiter ein zwischengewebtes Textilerzeugnis einschließen und davon gestützt werden.

## Revendications

1. Procédé de fabrication d'un boîtier de circuit intégré comprenant les étapes de :
assemblage d'un empilement qui est constitué d'une pluralité de couches diélectriques plates minces (11a à e), d'une cavité en forme d'escalier (13) qui s'étend à partir d'une couche diélectrique extérieure (11a) à travers une couche diélectrique interne (11c) et qui met à nu une partie de la face plate de ladite couche diélectrique interne (11c) et des conducteurs (15) sur ladite couche diélectrique interne (11c) comprenant des plots de liaison (15a) sur la partie de face plate mise à nu ;
recouvrement de ladite cavité (13) avec une membrane élastique (40a) ; et
jonction des couches (11a à d) dudit empilement de façon permanente en les comprimant avec un fluide (42) qui est forcé contre ladite membrane élastique (40a) à une température et une pression qui font que la membrane (40a) s'étire et se conforme exactement à la surface de ladite cavité (13) ; et relâchement de ladite membrane élastique (40a) par la décompression dudit fluide (42), ladite membrane élastique (40a) étant formée de telle manière qu'elle ait tendance à revenir à son état relâché.

2. Procédé selon la revendication 1, dans lequel lesdites couches diélectriques (11a à e) sont des couches de verre-époxy qui sont séparées par des couches d'adhésif (12a à d).

3. Procédé selon la revendication 1, dans lequel lesdites couches diélectriques (11a à e) sont des couches de céramique verte.

4. Procédé selon la revendication 1, dans lequel ladite membrane est une membrane en caoutchouc.

5. Procédé selon la revendication 1, dans lequel ladite membrane est une partie d'une vessie élastique (40) qui est fermée excepté en ce qui concerne une ouverture par laquelle passe ledit fluide.

6. Procédé selon la revendication 1, dans lequel ladite membrane (40a) présente une surface qui résiste au collage à ladite couche diélectrique (11a à d).

7. Procédé selon la revendication 1, dans lequel ladite membrane (40a) s'étend au-delà de ladite cavité (13) et recouvre la face plate de ladite couche diélectrique extérieure (11a).

8. Procédé selon la revendication 1, dans lequel lesdites température et pression sont respectivement, d'au moins 37,78°C (100°F) et d'au moins 344,74 kPa (50 psi).

9. Procédé selon la revendication 1, dans lequel ladite membrane s'étend sur une cavité et est fixée par son périmètre à un boîtier rigide.

10. Procédé selon la revendication 2, dans lequel lesdites couches adhésives (12a à d) comprennent des résines thermodurcissables qui ont été cuites à un stade intermédiaire.

11. Procédé selon la revendication 10, dans lequel lesdites couches adhésives (12a à d) comprennent en outre et sont supportées par un tissu broché.

12. Procédé selon la revendication 1, dans lequel lesdites couches diélectriques (11a à e) comprennent des résines thermodurcissables qui ont été cuites complètement.

13. Procédé selon la revendication 12, dans lequel lesdites couches diélectriques (11a à e) comprennent en outre et sont supportées par un tissu broché.
